# EUROPÄISCHE PATENTSCHRIFT

(11) **EP 0 605 361 B1**
(45) Veröffentlichungstag und Bekanntmachung des Hinweises auf die Patenterteilung: **02.04.1997**
(21) Anmeldenummer: 93810862.8
(22) Anmeldetag: 09.12.1993
(51) Int. Cl.: C08G 59/68, C08L 63/00, C08L 71/02, C08L 67/00, C08L 75/00, C08F 283/10, G03C 9/08

(54) **Photoempfindliche Zusammensetzungen**
Photosensitive compositions
Compositions photosensibles

(30) Priorität: 21.12.1992 CH 3906/92
(43) Veröffentlichungstag der Anmeldung: 06.07.1994
(73) Patentinhaber: Ciba Specialty Chemicals Holding Inc., 4057 Basel (CH)
(72) Erfinder: Steinmann, Bettina, Dr., CH-1724 Praroman (CH); Wolf, Jean-Pierre, Dr., CH-1791 Courtaman (CH); Schulthess, Adrian, Dr., CH-1734 Tentlingen (CH); Hunziker, Max, Dr., CH-3186 Düdingen (CH)

(56) Entgegenhaltungen:
- EP-A- 0 118 044
- EP-A- 0 144 148
- EP-A- 0 222 582
- EP-A- 0 320 237
- EP-A- 0 517 657

## Beschreibung

Die vorliegende Erfindung betrifft photoempfindliche Zusammensetzungen, ein Verfahren zum Polymerisieren dieser Zusammensetzungen mittels aktinischer Bestrahlung, sowie die Verwendung dieser Zusammensetzungen zur Herstellung von photopolymerisierten Schichten, insbesondere von dreidimensionalen Gegenständen, die aus mehreren photopolymerisierten Schichten aufgebaut sind.

Bekanntlich können strahlungsempfindliche, flüssige Harze oder Harzgemische vielseitig angewendet werden, beispielsweise als Beschichtungsmittel, Klebstoffe oder Photoresists. Im Prinzip sollten flüssige Harze oder Harzsysteme generell auch für die Herstellung von dreidimensionalen Gegenständen (3D-Objekten) nach dem im US-Patent 4,575,330 beschriebenen stereolithographischen Verfahren geeignet sein, doch erweisen sich manche Harze als zu viskos und andere wiederum genügen nach der Photohärtung nicht ganz den hohen Anforderungen bezüglich der Formgenauigkeit, die heutzutage an die so hergestellten Formkörper bzw. Gegenstände gestellt werden.

Mit einem stereolithographischen Verfahren können bekanntlich komplizierte dreidimensionale Gegenstände aus flüssigen, lichtempfindlichen Harzen hergestellt werden. Solche Gegenstände werden schichtweise aufgebaut, wobei jede neue härtbare Harzschicht durch Vorhärtung mittels UV/VIS-Licht mit der vorhergehenden, vorgehärteten Schicht fest verbunden wird. Der Gesamtaufbau des dreidimensionalen Gegenstandes lässt sich bekanntlich nach einem computergesteuerten Prozess bewerkstelligen. Bei diesem Verfahren der aufeinanderfolgenden Polymerisation von dünnen Schichten ist gewöhnlich keine dieser Schichten völlig ausgehärtet. Der nicht völlig gehärtete Gegenstand wird als Grünling bezeichnet, und den Elastizitätsmodul und die Bruchfestigkeit dieses Grünlings bezeichnet man auch als Grünfestigkeit (green strength). Normalerweise wird der Grünling dann mit UV/VIS-Licht gehärtet, beispielsweise mittels einer Quecksilber- oder Xenonbogenlampe. Die Grünfestigkeit eines Werkstückes stellt daher einen wichtigen Parameter dar, da Gegenstände mit einer geringen Grünfestigkeit sich unter ihrem eigenen Gewicht deformieren können, oder sie können sich bei der Aushärtung durchbiegen oder sacken zusammen.

Ein weiterhin in der Stereolithographie bekanntes Mass ist der sogenannte Curl-Faktor. Dieser Curl-Faktor dient dazu, Schwundphänomene der aus den verwendeten Harzsystemen hergestellen Formkörper bzw. Gegenstände zu charakterisieren. Die Bestimmung der Curl-Faktoren ist beispielsweise in "Proceedings 2^{nd} Int. Conference in Rapid Prototyping", Dayton, Ohio (1991) beschrieben.

In den letzten Jahren hat es nicht an Anstrengungen gefehlt, Harzsysteme zu entwickeln, welche für das stereolithographische Verfahren einsetzbar sind. JP Kokai 20 75,618 offenbart Gemische aus einem Epoxyharz, einem Acrylat, einem kationischen und einem radikalischen Photoinitiator, sowie einem OH-terminiertem Polyester. Die verwendete Acrylatkomponente enthält mindestens 50 % eines Acrylatmonomers mit mehr als 3 Doppelbindungen.

EP-A 360 869 offenbart ein Harzgemisch zur Formgebung mittels Licht, welches eine strahlungshärtbare und kationisch polymerisierbare organische Verbindung und einen kationischen Photoinitiator enthält, wobei gegebenenfalls noch weitere radikalisch polymerisierbare Komponenten, z.B. Polyacrylate, mitverwendet werden können.

Es wurde nun gefunden, dass strahlungsempfindliche Epoxy-Acrylat-Hybridsysteme, die ausserdem ein Polyol, einen OH-terminierten Polyester oder ein OH-terminiertes Polyurethan enthalten, für stereolithographische Verfahren eingesetzt werden können. Diese Harzsysteme zeichnen sich aus durch eine sehr niedrige Viskosität, einen sehr geringen Curl-Faktor und gute mechanische Eigenschaften im Grünzustand und nach der vollständigen Aushärtung.

Gegenstand der vorliegenden Erfindung ist somit eine photoempfindliche Zusammensetzungen enthaltend
A) 40-80 Gew.-% mindestens eines flüssigen Epoxyharzes mit einer Epoxidfunktionalität von gleich oder grösser als 2,
B) 0,1-10 Gew.-% mindestens eines kationischen Photoinitiators für Komponente A),
C) 5-40 Gew.-% mindestens eines flüssigen cycloaliphatischen oder aromatischen Diacrylats,
D) 0-15 Gew.-% mindestens eines flüssigen Poly(meth-)acrylats mit einer (Meth-)Acrylatfunktionalität von grösser als 2, wobei der Gehalt an Komponente D) am gesamten (Meth-)Acrylatgehalt höchstens 50 Gew.-% beträgt,
E) 0,1-10 Gew.-% mindestens eines radikalischen Photoinitiators für die Komponenten C) und gegebenenfalls D) und
F) 5-40 Gew.-% mindestens eines OH-terminierten Polyethers, Polyesters oder Polyurethans.

Die Gewichtsprozentangaben für die obigen Komponenten A) bis F) sind so zu verstehen, dass die Summe aller eingesetzten Komponenten immer 100 Gew.-% beträgt.

Bevorzugt sind Zusammensetzungen, wobei der Gehalt an Komponente D) am gesamten (Meth)Acrylatgehalt höchstens 40 Gew.-% beträgt.

Vorzugsweise enthält die photoempfindliche Zusammensetzungen
A) 50-75 Gew.-% mindestens eines flüssigen Epoxyharzes mit einer Epoxidfunktionalität von gleich oder grösser als 2,
B) 0,2-5 Gew.-% mindestens eines kationischen Photoinitiators für Komponente A),
C) 5-20 Gew.-% mindestens eines flüssigen cycloaliphatischen oder aromatischen Diacrylats,
D) 0-10 Gew.-% mindestens eines flüssigen Polyacrylats mit einer Acrylatfunktionalität von grösser als 2, wobei der Gehalt an Komponente D) am gesamten Acrylatgehalt höchstents 50 Gew.-% beträgt,
E) 0,2-5 Gew.-% mindestens eines radikalischen Photoinitiators für die Komponenten C) und gegebenenfalls D) und
F) 10-40 Gew.-% mindestens eines OH-terminierten Polyethers, Polyesters oder Polyurethans.

Bei den flüssigen Epoxyharzen, die in den erfindungsgemässen Zusammensetzungen Verwendung finden, handelt es sich um Verbindungen, die im Durchschnitt mehr als eine 1,2-Epoxidgruppen im Molekül besitzen.

Solche Harze können eine aliphatische, aromatische, cycloaliphatische, araliphatische oder heterocyclische Struktur haben; sie enthalten Epoxidgruppen als Seitengruppen, oder diese Gruppen bilden einen Teil eines alicyclischen oder heterocyclischen Ringsystems. Epoxyharze dieser Typen sind allgemein bekannt und im Handel erhältlich.

Beispielhaft für Epoxyharze dieses Typs sind zu erwähnen:
I) Polyglycidyl- und Poly-(β-methylglycidyl)-ester erhältlich durch Umsetzung einer Verbindung mit mindestens zwei Carboxylgruppen im Molekül und Epichlorhydrin bzw. Glycerindichlorhydrin bzw. β-Methyl-epichlorhydrin. Die Umsetzung erfolgt zweckmässig in Gegenwart von Basen.
   Als Verbindungen mit mindestens zwei Carboxylgruppen im Molekül können aliphatische Polycarbonsäuren verwendet werden. Beispiele für diese Polycarbonsäuren sind Glutarsäure, Adipinsäure, Pimelinsäure, Korksäure, Azelainsäure, Sebazinsäure oder dimerisierte bzw. trimerisierte Linolsäure.
   Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure.
   Weiterhin können aromatische Polycarbonsäuren Verwendung finden, wie beispielsweise Phthalsäure, Isophthalsäure, Trimellitsäure oder Pyromellitsäure.
   Ebenfalls können auch carboxylterminierte Addukte, z.B. von Trimellitsäure und Polyolen, wie beispielsweise Glycerin oder 2,2-Bis-(4-hydroxycyclohexyl)-propan, verwendet werden.
II) Polyglycidyl- oder Poly-(β-methylglycidyl)-ether erhältlich durch Umsetzung einer Verbindung mit mindestens zwei freien alkoholischen Hydroxygruppen und/oder phenolischen Hydroxygruppen und einem geeignet substituierten Epichlorhydrin unter alkalischen Bedingungen, oder in Anwesenheit eines sauren Katalysators und anschliessender Alkalibehandlung.
   Ether dieses Typs leiten sich beispielsweise ab von acyclischen Alkoholen, wie Ethylenglykol, Diethylenglykol und höheren Poly-(oxyethylen)-glykolen, Propan-1,2-diol, oder Poly-(oxypropylen)-glykolen, Propan-1,3-diol, Butan-1,4-diol, Poly-(oxytetramethylen)-glykolen, Pentan-1,5-diol, Hexan-1,6-diol, Hexan-2,4,6-triol, Glycerin, 1,1,1-Trimethylolpropan, Bistrimethylolpropan, Pentaerythrit, Sorbit, sowie von Polyepichlorhydrinen.
   Sie leiten sich aber auch beispielsweise ab von cycloaliphatischen Alkoholen, wie 1,3- oder 1,4-Dihydroxycyclohexan, Bis-(4-hydroxycyclohexyl)-methan, 2,2-Bis-(4-hydroxycyclohexyl)-propan oder 1,1-Bis-(hydroxymethyl)-cyclohex-3-en, oder sie besitzen aromatische Kerne, wie N,N-Bis-(2-hydroxyethyl)-anilin oder p,p'-Bis-(2-hydroxyethylamino)-diphenylmethan.
   Die Epoxidverbindungen können sich auch von einkernigen Phenolen ableiten, wie beispielsweise von Resorcin oder Hydrochinon, oder sie basieren auf mehrkernigen Phenolen, wie beispielsweise auf Bis-(4-hydroxyphenyl)-methan (Bisphenol F), 2,2-Bis(4-hydroxyphenyl)-propan (Bisphenol A), oder auf unter sauren Bedingungen erhaltenen Kondensationsprodukten von Phenolen oder Kresolen mit Formaldehyd, wie Phenol-Novolake und Kresol-Novolake.
III) Poly-(N-glycidyl)-Verbindungen sind beispielsweise erhältlich durch Dehydrochlorierung der Reaktionsprodukte von Epichlorhydrin mit Aminen, die mindestens zwei Aminwasserstoffatome enthalten. Bei diesen Aminen handelt es sich zum Beispiel um n-Butylamin, Anilin, Toluidin, m-Xylylendiamin, Bis-(4-aminophenyl)-methan oder Bis-(4-methylaminophenyl)-methan.
   Zu den Poly-(N-glycidyl)-Verbindungen zählen aber auch N,N'-Diglycidylderivate von Cycloalkylenharnstoffen, wie Ethylenharnstoff oder 1,3-Propylenharnstoff, und N,N'-Diglycidylderivate von Hydantoinen, wie von 5,5-Dimethylhydantoin.
IV) Beispiele für Poly-(S-glycidyl)-Verbindungen sind Di-S-glycidylderivate, die sich von Dithiolen, wie beispielsweise Ethan-1,2-dithiol oder Bis-(4-mercaptomethylphenyl)-ether, ableiten.
V) Beispiele für Epoxidverbindungen, worin die Epoxidgruppen einen Teil eines alicyclischen oder heterocyclischen Ringsystems bilden, sind beispielsweise Bis-(2,3-epoxicyclopentyl)-ether, 2,3-Epoxicyclopentylglycidylether, 1,2-Bis-(2,3-epoxicyclopentyloxy)-ethan, Bis-(4-hydroxycyclohexyl)-methandiglycidylether, 2,2-Bis-(4-hydroxycyclohexyl)-propandiglycidylether, 3,4-Epoxycyclohexylmethyl-3,4-epoxycyclohexancarboxylat, 3,4-Epoxy-6-methyl-cyclohexylmethyl-3,4-epoxy-6-methylcyclohexancarboxylat, Di-(3,4-epoxycyclohexylmethyl)hexandioat, Di-(3,4-epoxy-6-methyl-cyclohexylmethyl)-hexandioat, Ethylenbis-(3,4-epoxycyclohexancarboxylat), Ethandioldi-(3,4-epoxycyclohexylmethyl)-ether, Vinylcyclohexendioxid, Dicyclopentadiendiepoxid oder 2-(3,4-Epoxycyclohexyl-5,5-spiro-3,4-epoxy)cyclohexan-1,3-dioxan.

Es lassen sich aber auch Epoxyharze verwenden, bei denen die 1,2-Epoxidgruppen an unterschiedliche Heteroatome bzw. funktionelle Gruppen gebunden sind. Zu diesen Verbindungen zählen beispielsweise das N,N,O-Triglycidylderivat des 4-Aminophenols, der Glycidylether-glycidylester der Salicylsäure, N-Glycidyl-N'-(2-glycidyloxypropyl)-5,5-dimethylhydantoin oder 2-Glycidyloxy-1,3-bis-(5,5-dimethyl-1-glycidylhydantoin-3-yl)propan.

Ferner sind auch flüssige vorreagierte Addukte solcher Epoxyharze mit Härtern für Epoxyharze geeignet.

Natürlich können auch Mischungen von Epoxyharzen in den erfindungsgemässen Zusammensetzungen verwendet werden.

Bevorzugt sind Zusammensetzungen, worin die Komponente A) mindestens 50 Gew.-% eines cycloaliphatischen Diepoxids enthält.

Insbesondere bevorzugt sind Zusammensetzungen, wobei das cycloaliphatische Diepoxid Bis-(4-hydroxycyclohexyl)-methandiglycidylether, 2,2-Bis-(4-hydroxycyclohexyl)-propandiglycidylether, 3,4-Epoxycyclohexylmethyl-3,4-epoxycyclohexancarboxylat, 3,4-Epoxy-6-methyl-cyclohexylmethyl-3,4-epoxy-6-methylcyclohexancarboxylat, Di-(3,4-epoxycyclohexylmethyl)hexandioat, Di-(3,4-epoxy-6-methyl-cyclohexylmethyl)hexandioat, Ethylenbis-(3,4-epoxycyclohexancarboxylat), Ethandioldi-(3,4-epoxycyclohexylmethyl)-ether oder 2-(3,4-Epoxycyclohexyl-5,5-spiro-3,4-epoxy)cyclohexan-1,3-dioxan ist.

Als Komponente B) der erfindungsgemässen Zusammensetzungen lassen sich eine Vielzahl bekannter und in der Technik erprobter kationischer Photoinitiatoren für Epoxyharze einsetzen. Dabei handelt es sich beispielsweise um Oniumsalze mit Anionen schwacher Nukleophilie. Beispiele dafür sind Haloniumsalze, Iodosylsalze oder Sulfoniumsalze, wie sie in der EP-A 153 904 beschrieben sind, Sulfoxoniumsalze, wie beispielsweise in den EP-A 35 969, 44 274, 54 509 und 164 314 beschrieben oder Diazoniumsalze, wie beispielsweise in der US-A 3,708,296 beschrieben. Weitere kationische Photoinitiatoren sind Metallocensalze, wie bespielsweise in den EP-A 94 914 und 94 915 beschrieben.

Eine Übersicht über weitere gängige Oniumsalzinitiatoren und/oder Metallocensalze bieten "UV-Curing, Science and Technology", (Editor: S.P. Pappas, Technology Marketing Corp., 642 Westover Road, Stanford, Conneticut, USA) oder "Chemistry & Technology of UV & EB Formulation for Coatings, Inks & Paints", Vol. 3 (edited by P. K. T. Oldring).

Bevorzugt sind Zusammensetzungen enthaltend als Komponente B) eine Verbindung der Formeln I, II oder III 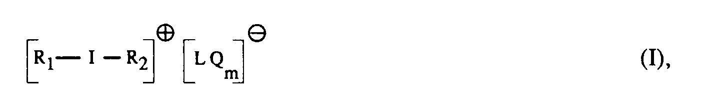 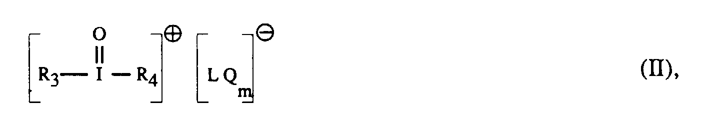 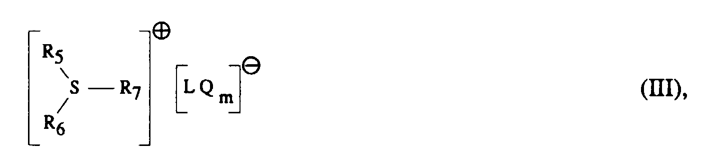 worin R₁, R₂, R₃, R₄, R₅, R₆ und R₇ unabhängig voneinander unsubstituiertes oder durch geeignete Reste substituiertes C₆-C₁₈-Aryl bedeuten,
- L: Bor, Phosphor, Arsen oder Antimon darstellt,
- Q: ein Halogenatem ist oder ein Teil der Reste Q in einem Anion LQₘ⁻ auch Hydroxylgruppen sein kann und
- m: eine ganze Zahl ist, die der um 1 vergrösserten Wertigkeit von L entspricht.

Beispiele für C₆-C₁₈-Aryl sind Phenyl, Naphthyl, Anthryl und Phenanthryl. Gegebenenfalls vorliegende Substituenten für geeignete Reste sind Alkyl, bevorzugt C₁-C₆-Alkyl, wie Methyl, Ethyl, n-Propyl, Isopropyl, n-Butyl, sec-Butyl, Isobutyl, tert-Butyl oder die verschiedenen Pentyl- oder Hexyl-Isomere, Alkoxy, bevorzugt C₁-C₆-Alkoxy, wie Methoxy, Ethoxy, Propoxy, Butoxy, Pentoxy oder Hexoxy, Alkylthio, bevorzugt C₁-C₆-Alkylthio, wie Methylthio, Ethylthio, Propylthio, Butylthio, Pentylthio oder Hexylthio, Halogen, wie Fluor, Chlor, Brom oder Jod, Aminogruppen, Cyanogruppen, Nitrogruppen oder Arylthio, wie Phenylthio.

Beispiele für bevorzugte Halogenatome Q sind Chlor und insbesondere Fluor. Bevorzugte Anionen LQₘ⁻ sind BF₄⁻, PF₆⁻, AsF₆⁻, SbF₆⁻ und SbF₅(OH)⁻.

Besonders bevorzugt sind Zusammensetzungen enthaltend als Komponente B) eine Verbindung der Formel III, worin R₅, R₆ und R₇ Aryl sind, wobei Aryl vor allem Phenyl oder Biphenyl oder Gemische dieser beiden Verbindungen bedeutet.

Weiterhin bevorzugt sind Zusammensetzungen enthaltend als Komponente B) eine Verbindung der Formel IV 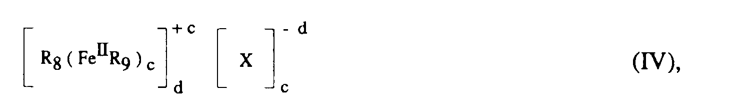 worin c 1 oder 2 bedeutet,
- d: 1, 2, 3, 4 oder 5 ist,
- X: für ein nicht nukleophiles Anion, insbesondere PF₆⁻, AsF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻ und n-C₈F₁₇SO₃⁻ steht,
- R₈: ein π-Aren ist und
- R₉: ein Anion eines π-Arens, insbesondere ein Cyclopentadienylanion, bedeutet.

Beispiele für π-Arene als R₈ und Anionen von π-Arenen R₉ als findet man in der EP-A 94 915.

Beispiele für bevorzugte π-Arene als R₈ sind Toluol, Xylol, Ethylbenzol, Cumol, Methoxybenzol, Methylnaphthalin, Pyren, Perylen, Stilben, Diphenylenoxid und Diphenylensulfid.

Insbesondere bevorzugt sind Cumol, Methylnaphthalin oder Stilben.

Beispiele für nicht nukleophile Anionen X⁻ sind FSO₃⁻, Anionen von organischen Sulfonsäuren, von Carbonsäuren oder von Anionen LQₘ⁻, wie bereits oben definiert.

Bevorzugte Anionen leiten sich ab von teilfluor- oder perfluoraliphatischen oder teilfluor- oder perfluoraromatischen Carbonsäuren, oder insbesondere von teilfluor- oder perfluoraliphatischen oder teilfluor- oder perfluoraromatischen organischen Sulfonsäuren oder es handelt sich bevorzugt um Anionen LQₘ⁻.

Beispiele für Anionen X sind BF₄⁻, PF₆⁻, AsF₆⁻, SbF₆⁻, SbF₅(OH)⁻, CF₃SO₃⁻, C₂F₅SO₃⁻, n-C₃F₇SO₃⁻, n-C₄F₉SO₃⁻, n-C₆F₁₃SO₃⁻, n-C₈F₁₇SO₃⁻, C₆F₅SO₃⁻, Phosphorwolframat (PO₄₀W₁₂³⁻) oder Siliciumwolframat (SiO₄₀W₁₂⁴⁻).

Bevorzugt werden PF₆⁻, AsF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻ und n-C₈F₁₇SO₃⁻.

Die Metallocensalze können auch in Kombination mit Oxidationsmitteln eingesetzt werden. Solche Kombinationen sind in der EP-A 126 712 beschrieben.

Zur Erhöhung der Lichtausbeute können je nach Initiatortyp auch Sensibilisatoren eingesetzt werden. Beispiele hierfür sind polycyclische aromatische Kohlenwasserstoffe oder aromatische Ketoverbindungen. Spezifische Beispiele bevorzugter Sensibilisatoren sind in der EP-A 153 904 erwähnt.

Als Komponente C) eignen sich beispielsweise die Diacrylate von cycloaliphatischen oder aromatischen Diolen, wie 1 ,4-Dihydroxymethylcyclohexan, 2,2-Bis-(4-hydroxycyclohexyl)-propan, Bis-(4-hydroxycyclohexyl)-methan, Hydrochinon, 4,4',-Dihydroxybiphenyl, Bisphenol A, Bisphenol F, Bisphenol S, ethoxyliertes oder propoxyliertes Bisphenol A, ethoxyliertes oder propoxyliertes Bisphenol F oder ethoxyliertes oder propoxyliertes Bisphenol S. Solche Diacrylate sind bekannt und zum Teil im Handel erhältlich.

Bevorzugt sind Zusammensetzungen enthaltend als Komponente C) eine Verbindung der Formeln V, VI, VII oder VIII 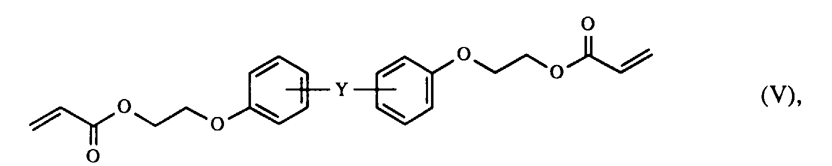 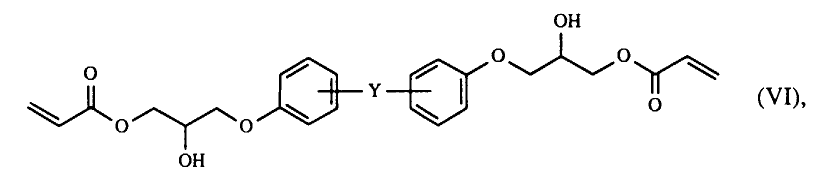 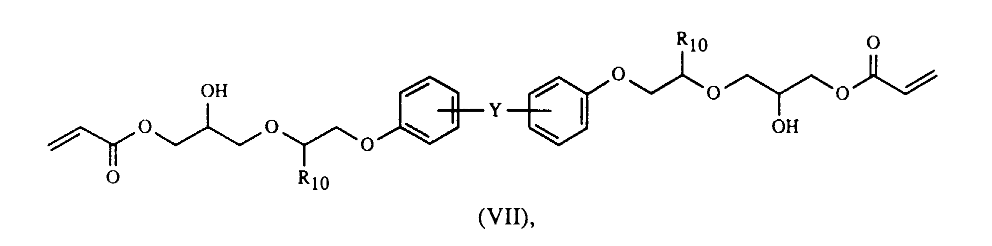 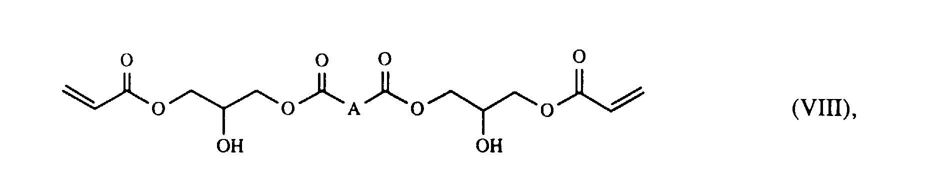 wobei
- Y: für eine direkte Bindung, C₁-C₆-Alkylen, -S-, -O-, -SO-, -SO₂- oder -CO- steht,
- R₁₀: für eine C₁-C₈-Alkylgruppe, eine unsubstituierte oder durch eine oder mehrere C₁-C₄-Alkylgruppen, Hydroxygruppen oder Halogenatome substituierte Phenylgruppe, oder für einen Rest der Formel -CH₂-OR₁₁ steht, worin
- R₁₁: eine C₁-C₈-Alkylgruppe oder Phenylgruppe bedeutet,
- A: einen Rest der Formeln 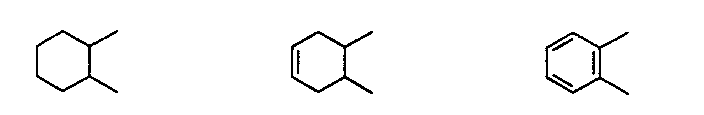 darstellt,
oder enthaltend als Komponente C) eine Verbindung der Formeln IXa bis IXd 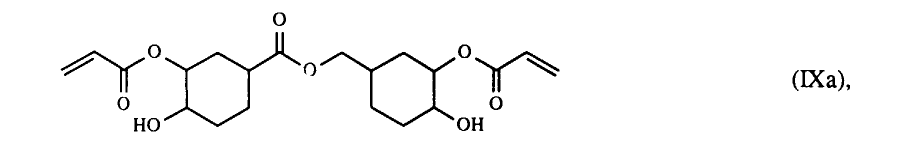 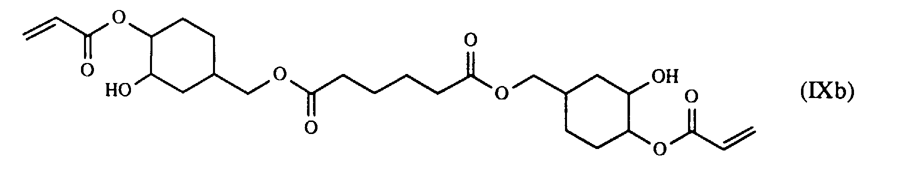 und die entsprechende Isomere,

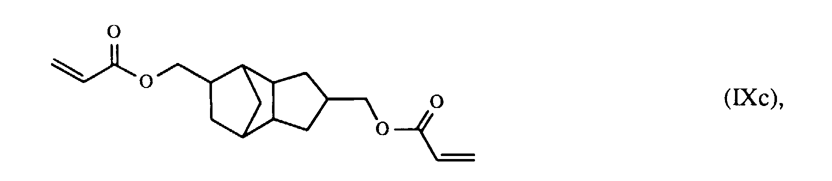

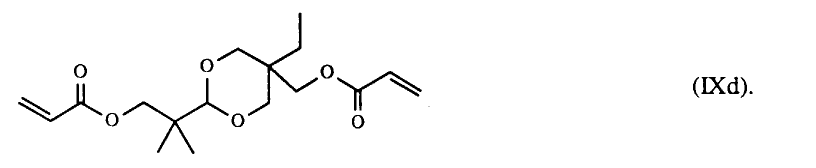

Bedeutet ein Substituent C₁-C₄-Alkyl oder C₁-C₈-Alkyl, so kann dieser gradkettig oder verzweigt sein. Beispielsweise handelt es sich bei C₁-C₄-Alkyl um Methyl, Ethyl, n-Propyl, Isopropyl, n-Butyl, sec-Butyl, Isobutyl oder tert-Butyl, bei C₁-C₈-Alkyl zusätzlich um die verschiedenen Pentyl-, Hexyl-, Heptyl- oder Octyl-Isomere.

Bedeutet ein Substituent Halogen, so handelt es sich um Fluor, Chlor, Brom oder Jod, insbesondere aber um Chlor und Brom.

Stellt ein Substituent C₁-C₆-Alkylen dar, so handelt es sich beispielsweise um Methylen, Ethylen, Propylen (Methylethylen), Trimethylen, 1,1-Propandiyl, 2,2-Propandiyl, Tetramethylen, Ethylmethylen, 1,1-Butandiyl, 2,2-Butandiyl, Pentamethylen oder Hexamethylen. Die Alkylenreste können auch durch Halogenatome substituiert sein. Beispiele für halogenierte Alkylenreste sind -C(CCl₃)₂- und -C(CF₃)₂-.

Insbesondere bevorzugt in den Zusammensetzungen sind Verbindungen der Formeln V, VI oder VII, worin Y für -CH₂- oder -C(CH₃)₂- steht.

Ebenfalls besonders bevorzugt sind Verbindungen der Formel VII, worin R₁₀ für n-Butyl, Phenyl, n-Butoxymethyl oder Phenoxymethyl steht.

Die in den erfindungsgemässen Zusammensetzungen gegebenenfalls als Komponente D) verwendeten flüssigen Poly(meth-)acrylate mit einer (Meth-)Acrylatfunktionalität von grösser als 2 können beispielsweise tri-, tetra- oder pentafunktionelle monomere oder oligomere aliphatische, cycloaliphatische oder aromatische Acrylate oder Methacrylate sein.

Als aliphatische polyfunktionelle (Meth-)Acrylate eignen sich beispielsweise die Triacrylate und Trimethacrylate von Hexan-2,4,6-triol, Glycerin oder 1,1,1-Trimethylolpropan, ethoxyliertes oder propoxyliertes Glycerin oder 1,1,1-Trimethylolpropan und die hydroxygruppenhaltigen Tri(meth-)acrylate, die durch Umsetzung von Triepoxidverbindungen, wie beispielsweise die Triglycidylether von den genannten Triolen, mit (Meth-)Acrylsäure erhalten werden. Weiterhin können zum Beispiel Pentaerythritoltetraacrylat, Bistrimethylolpropantetraacrylat, Pentaerythritolmonohydroxytriacrylat oder -methacrylat oder Dipentaerythritolmonohydroxypentaacrylat oder -methacrylat verwendet werden.

Ausserdem können hexafunktionelle Urethanacrylate oder Urethanmethacrylate verwendet werden. Diese Urethan(meth-)acrylate sind dem Fachmann bekannt und können in bekannter Weise hergestellt werden, indem man beispielsweise ein hydroxylterminiertes Polyurethan mit Acrylsäure oder Methacrylsäure umsetzt, oder indem man ein isocyanatterminiertes Präpolymer mit Hydroxyalkyl(meth-)acrylaten zum Urethan(meth-)acrylat umsetzt.

Als aromatische Tri(meth-)acrylate eignen sich beispielsweise die Umsetzungsprodukte aus Triglycidylethern dreiwertiger Phenole und drei Hydroxylgruppen aufweisende Phenol- oder Kresolnovolake mit (Meth)-Acrylsäure.

Die als Komponente D) eingesetzten (Meth-)Acrylate stellen bekannte Verbindungen dar und sind zum Teil im Handel erhältlich, beispielsweise von den Firmen SARTOMER Company und UCB.

Bevorzugt sind Zusammensetzungen, worin die Komponente D) ein Tri(meth-)acrylat oder ein Penta(meth-)acrylat ist.

Insbesondere bevorzugt sind Zusammensetzungen, worin die Komponente D) Dipentaerythritolmonohydroxypenta(meth-)acrylat ist.

In den erfindungsgemässen Zusammensetzungen können alle Typen von Photoinitiatoren als Komponente E) eingesetzt werden, welche bei der entsprechenden Bestrahlung freie Radikale bilden. Typische Verbindungen bekannter Photoinitiatoren sind Benzoine, wie Benzoin, Benzoinether, wie Benzoinmethylether, Benzoinethylether und Benzoinisopropylether, Benzoinphenylether und Benzoinacetat, Acetophenone, wie Acetophenon, 2,2-Dimethoxyacetophenon und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert-Butylanthrachinon, 1-Chloranthrachinon und 2-Amylanthrachinon, ferner Triphenylphosphin, Benzoylphosphinoxide, wie beispielsweise 2,4,6-Trimethylbenzoyldiphenylphosphinoxid(Luzirin® TPO), Benzophenone, wie Benzophenon und 4,4'-Bis-(N,N'-dimethylamino)-benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton, welche alle bekannte Verbindungen darstellen.

Besonders geeignete Photoinitiatoren, welche gewöhnlich in Kombination mit einem He/Cd-Laser als Lichtquelle verwendet werden, sind Acetophenone, wie 2,2-Dialkoxybenzophenone und -Hydroxyphenylketone, beispielsweise 1 1-Hydroxycyclohexylphenylketon oder 2-Hydroxyisopropylphenylketon (= 2-Hydroxy-2,2-dimethylacetophenon), insbesondere aber 1-Hydroxycyclohexylphenylketon.

Eine andere Klasse von Photoinitiatoren E), die gewöhnlich bei Verwendung von Argonion-Lasern eingesetzt wird, sind die Benzilketale, wie beispielsweise Benzildimethylketal. Insbesondere verwendet man als Photoinitiator ein α-Hydroxyphenylketon, Benzildimethylketal oder 2,4,6-Trimethylbenzoyldiphenylphosphinoxid.

Eine weitere Klasse von geeigneten Photoinitiatoren E) stellen die ionischen Farbstoff-Gegenionverbindungen (ionic dye-counter ion compound) dar, welche in der Lage sind, aktinische Strahlen zu absorbieren und freie Radikale zu erzeugen, die die Polymerisation der Acrylate initiieren können. Die erfindungsgemässen Zusammensetzungen, welche ionische Farbstoff-Gegenionverbindungen enthalten, können auf diese Weise variabler mit sichtbarem Licht im einstellbaren Wellenlängenbereich von 400-700 nm gehärtet werden. Ionische Farbstoff-Gegenionverbindungen und deren Wirkungsweise sind bekannt, beispielsweise aus EP-A 223 587 und den US-Patenten 4,751,102, 4,772,530 und 4,772,541. Als Beispiele für geeignete ionische Farbstoff-Gegenionverbindungen seien genannt die anionischen Farbstoff-Jodoniumionkomplexe, die anionischen Farbstoff-Pyrylliumionkomplexe und insbesondere die kationischen Farbstoff-Boratanionverbindungen der folgenden Formel 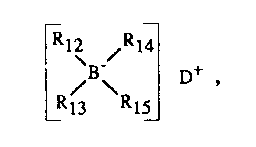 worin D⁺ für einen kationischen Farbstoff steht und R₁₂, R₁₃, R₁₄ und R₁₅ unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten. Bevorzugte Definitionen für die Reste R₁₂ bis R₁₅ können beispielsweise aus EP-A 223 587 entnommen werden.

Die Photoinitiatoren werden bekanntlich in wirksamen Mengen zugesetzt, das heisst, in Mengen von 0,1 bis 10 Gewichtsprozent, bezogen auf die Gesamtmenge der Zusammensetzung. Wenn die erfindungsgemässen Zusammensetzungen für stereolithographische Verfahren verwendet werden, wobei normalerweise Laserstrahlen eingesetzt werden, ist es wesentlich, dass die Absorptionsfähigkeit der Zusammensetzung durch Typ und Konzentration der Photoinitiatoren so abgestimmt wird, dass die Härtungstiefe bei normaler Lasergeschwindigkeit ungefähr 0,1 bis 2,5 mm beträgt.

Vorzugsweise enthalten die erfindungsgemässen Zusammensetzungen als Photoinitiator E) ein 1-Hydroxyphenylketon, insbesondere 1-Hydroxycyclohexylphenylketon.

Die als Komponente F) eingesetzten OH-terminierten Polyether, Polyester oder Polyurethane sind dem Fachmann bekannt und teilweise im Handel erhältlich, wie zum Beispiel TONE® Polyol 0301 der Fa. Union Carbide oder Desmophen® 1600 und Desmophen® 1915 der Fa. Bayer AG.

Bevorzugt sind Zusammensetzungen enthaltend als Komponente F) ein lineares oder verzweigtes Polyesterpolyol.

Ebenfalls bevorzugt sind Zusammensetzungen enthaltend als Komponente F) ein trifunktionelles, OH-terminiertes Polycaprolacton.

Insbesondere bevorzugt sind photoempfindliche Zusammensetzungen, enthaltend
als Komponente A) ein cycloaliphatisches Diepoxid und einen aliphatischen Polyglycidylether,
als Komponente B) Triarylsulfoniumhexafluoroantimonat,
als Komponente C) eine Verbindung der Formel VI, worin Y -CH₂- oder -C(CH₃)₂- ist,
als Komponente D) ein Tri(meth-)acrylat oder ein Penta(meth-)acrylat,
als Komponente E) ein 1-Hydroxyphenylketon und
als Komponente F) ein lineares oder verzweigtes Polyesterpolyol.

Falls erwünscht können den erfindungsgemässen Zusammensetzungen die üblichen Additive G) zugesetzt werden, beispielsweise Stabilisatoren, wie UV-Stabilisatoren, Polymerisationsinhibitoren, Trennmittel, Benetzungsmittel, Verlaufsmittel, Sensibilisatoren, Antiabsetzmittel, oberflächenaktive Mittel, Farbstoffe, Pigmente oder Füllstoffe.

Die erfindungsgemässen Zusammensetzungen können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter, zweckmässig in Abwesenheit von Licht und gegebenenfalls bei leicht erhöhter Temperatur.

Die erfindungsgemässen, photoempfindlichen Zusammensetzungen können durch Bestrahlen mit aktinischem Licht, beispielsweise mittels Elektronenstrahlen, Röntgenstrahlen, UV- oder VIS-Licht, das heisst, mit elektromagnetischer Strahlung oder Teilchenstrahlung im Wellenlängenbereich von 280-650 nm, polymerisiert werden. Besonders geeignet sind Laserstrahlen von He/Cd-, Argon- oder Stickstoff- sowie Metalldampf- und NdYAG-Lasern mit vervielfachter Frequenz. Es ist dem Fachmann bekannt, dass für jede gewählte Lichtquelle die geeigneten Photoinitiatoren ausgewählt und gegebenenfalls sensibilisiert werden müssen. Man hat erkannt, dass die Eindringtiefe der Strahlung in die zu polymerisierende Zusammensetzung und die Arbeitsgeschwindigkeit in direktem Zusammenhang mit dem Absorptionskoeffizienten und der Konzentration der Photoinitiatoren stehen.

Die erfindungsgemässen Zusammensetzungen können auch verschiedene Photoinitiatoren enthalten, welche gegenüber Strahlen von Emissionslinien unterschiedlicher Wellenlänge verschieden strahlungsempfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Gegenstand der Erfindung ist somit auch ein Verfahren zum Polymerisieren der erfindungsgemässen Zusammensetzungen, indem diese mit aktinischem Licht bestrahlt werden. Die erhaltenen Polymerisate können beispielsweise als Beschichtungsmittel, Photoresists oder Klebstoffe verwendet werden.

Es war nicht voraussehbar, dass aus den erfindungsgemässen Zusammensetzungen, die Diacrylate mit aromatischen oder cycloaliphatischen Gruppen in derartigen Mengen enthalten, mittels stereolithographischen Verfahren Formkörper bzw. Gegenstände hergestellt werden können, die einen nicht messbaren oder äussert geringen Curl (Verzugserscheinungen) besitzen, insbesondere bei Verwendung von bestimmten Gewichtsverhältnissen an Komponenten C und D. Normalerweise werden bei der Verwendung von Diacrylaten ohne den erheblichen Zusatz von höherfunktionellen Acrylaten Formulierungen erhalten, die nach dem Belichtungsschritt weiterpolymerisieren und somit keine brauchbaren stereolithographisch hergestellten Teile ergeben.

Ein weiterer Erfindungsgegenstand ist auch ein Verfahren zur Herstellung von dreidimensionalen Gegenständen aus einer erfindungsgemässen Zusammensetzung mittels einem lithographischen Verfahren, insbesondere einem stereolithographischen Verfahren, wobei die Oberfläche einer Schicht aus der erfindungsgemässen Zusammensetzung ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus der erfindungsgemässen Zusammensetzung auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

Bei diesem Verfahren wird als UV/VIS-Lichtquelle vorzugsweise ein Laserstrahl verwendet, der in einer besonders bevorzugten Ausführungsform computergesteuert ist.

Werden die erfindungsgemässen Zusammensetzungen als Beschichtungsmittel eingesetzt, so erhält man klare und harte Beschichtungen auf Holz, Papier, Metall, Keramik oder anderen Oberflächen. Die Beschichtungsdicke kann dabei sehr variieren und etwa von 1 µm bis etwa 1 mm betragen. Aus den erfindungsgemässen Gemischen können Reliefbilder für gedruckte Schaltungen oder Druckplatten direkt durch Bestrahlen der Gemische hergestellt werden, beispielsweise mittels eines computergesteuerten Laserstrahls geeigneter Wellenlänge oder unter Anwendung einer Photomaske und einer entsprechenden Lichtquelle.

Eine weitere Verwendungsmöglichkeit ist der Einsatz der erfindungsgemässen Zusammensetzungen als photohärtbare Klebstoffe.

Vorzugsweise verwendet man die erfindungsgemässen Zusammensetzungen zur Herstellung von photopolymerisierten Schichten, insbesondere in Form von dreidimensionalen Gegenständen, die aus mehreren aneinander haftenden, verfestigten Schichten aufgebaut sind.

Die folgenden Beispiele erläutern die vorliegende Erfindung weiter.

### Beispiel 1:

64 g 3,4-Epoxycyclohexylmethyl-3',4'-epoxycyclohexancarboxylat werden mit 22 g eines trifunktionellen, OH-terminierten Polycaprolactons (TONE® Polyol 0301 der Fa. Union Carbide) und 12 g Bisphenol-A-diglycidylether-diacrylat (Novacure® 3700 der Fa. Radcure) bei 60 °C vermischt. Anschliessend werden 1 g 1-Hydroxycyclohexylphenylketon (Irgacure® 184 der Fa. Ciba-Geigy) und 1 g Triarylsulfoniumhexafluoroantimonat (Cyracure® UVI 6974 der Fa. Union Carbide) hinzugegeben, und das Gemisch wird dann so lange gerührt, bis eine klare homogene Mischung entsteht. Die flüssige Formulierung hat bei 30 °C eine Viskosität von 618 mPa·s.
Mit Hilfe eines He/Cd-Lasers (Bestrahlungsenergie: 40 mJ/cm²) werden Formkörper hergestellt. Nach der Laserhärtung (Grünlinge) haben diese Körper folgende Eigenschaften:

| | |
|---|---|
| E-Modul: | 1100 N/mm² |
| (Elastizitätsmodul gemäss DIN 53371; green strength); | |
| Reissdehnung: | 6,3 % |
| (gemäss DIN 53455). | |

Zur vollständigen Aushärtung werden die Grünlinge 30 Minuten mit UV-Licht bestrahlt und 30 Minuten auf 130 °C erwärmt. Die Körper weisen anschliessend folgende Eigenschaften auf:

| | |
|---|---|
| E-Modul: | 1450 N/mm² |
| Reissdehnung: | 2,5 % |
| Curl-Faktor: | CF 6: 0,01 |
| | CF 11: 0,02. |

Der Curl-Faktor ist in der Stereolithographie ein bekanntes Mass, um die Schwundphänomene verschiedener Mischungen miteinander zu vergleichen (siehe z.B. Proceedings 2^{nd} Int. Conference in Rapid Prototyping, Dayton, Ohio (1991)). Die angegebenen Curl-Faktoren werden an Formkörpern bestimmt, die mit einer Schichtdicke von 0,076 mm aufgebaut wurden.

### Beispiel 2:

55 g 3,4-Epoxycyclohexylmethyl-3',4'-epoxycyclohexancarboxylat werden mit 18 g Butandioldiglycidylether, 13 g eines trifunktionellen, OH-terminierten Polycaprolactons (TONE® Polyol 0301 der Fa. Union Carbide) und 12 g ethoxyliertem Bisphenol-A-diacrylat (SR® 349 der Fa. Sartomer) bei 60 °C vermischt. Anschliessend werden 1 g 1-Hydroxycyclohexylphenylketon (Irgacure® 184 der Fa. Ciba-Geigy) und 1 g Triarylsulfoniumhexafluoroantimonat (Cyracure® UVI 6974 der Fa. Union Carbide) hinzugegeben, und das Gemisch wird dann solange gerührt, bis eine klare homogene Mischung entsteht. Die flüssige Formulierung hat bei 30 °C eine Viskosität von 138 mPa·s.
Mit Hilfe eines He/Cd-Lasers (Bestrahlungsenergie: 320 mJ/cm²) werden Formkörper hergestellt. Nach der Laserhärtung (Grünlinge) haben diese Körper folgende Eigenschaften:

| | |
|---|---|
| E-Modul: | 1320 N/mm² |
| Reissdehnung: | 6,4 % |

Zur vollständigen Aushärtung werden die Grünlinge 30 Minuten mit UV-Licht bestrahlt und 30 Minuten auf 130 °C erwärmt. Die Körper weisen anschliessend folgende Eigenschaften auf:

| | |
|---|---|
| E-Modul: | 1580 N/mm² |
| Reissdehnung: | 4,3 % |
| Curl-Faktor: | CF 6: 0,01 |
| | CF 11: 0,02. |

### Beispiele 3 - 13:

Es werden wie in Beispiel 1 Formulierungen aus den in Tabelle 1 angegebenen Komponenten hergestellt. Die Mengenangaben sind Gewichts-%, bezogen auf das Gesamtgewicht der entsprechenden Formulierung. Die Viskositäten dieser Gemische sind ebenfalls in Tabelle 1 aufgeführt. Mit Hilfe eines He/Cd-Lasers werden Formkörper hergestellt. Die Eigenschaften der erhaltenen Formkörper sind in Tabelle 2 angegeben.

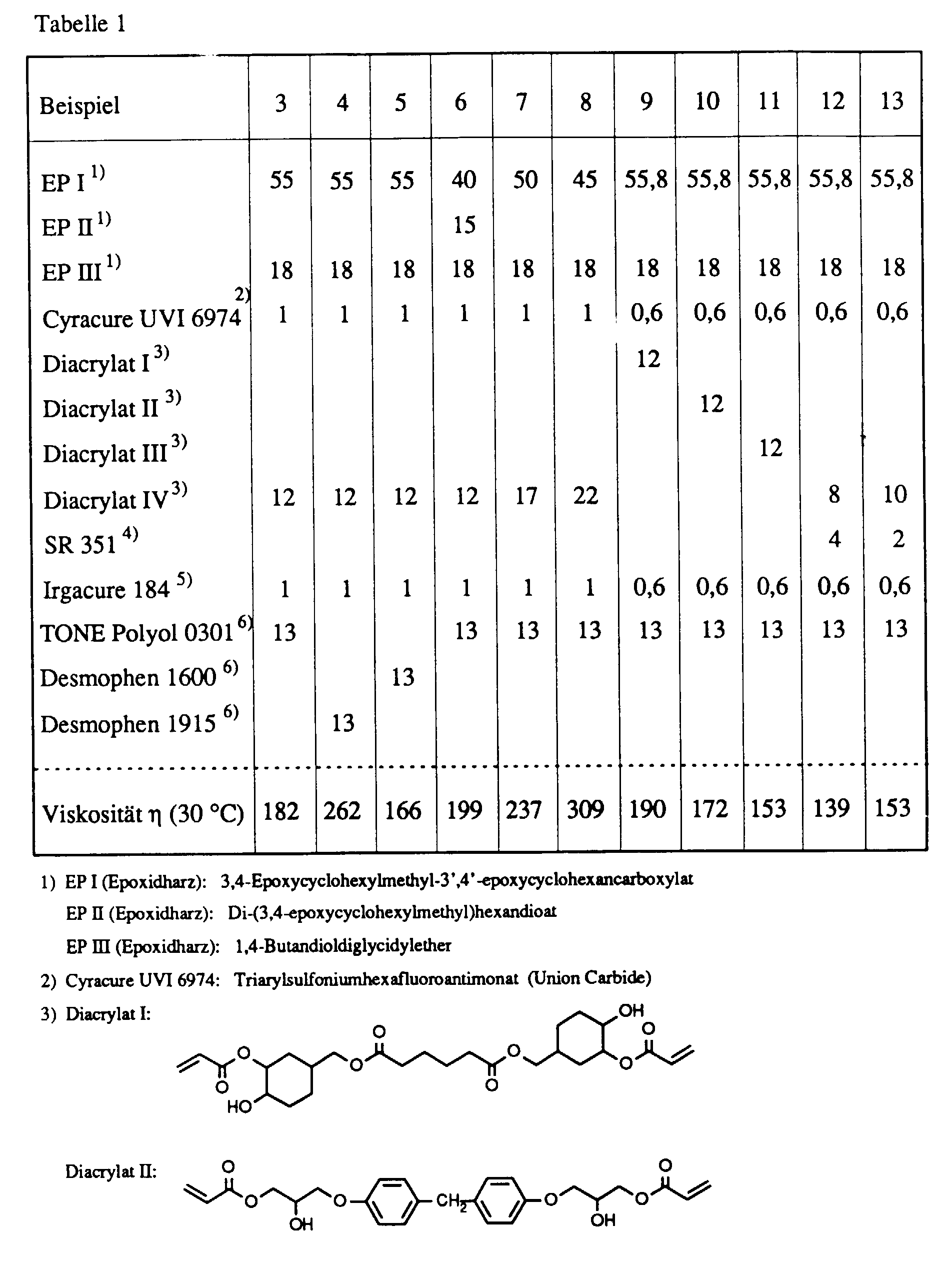

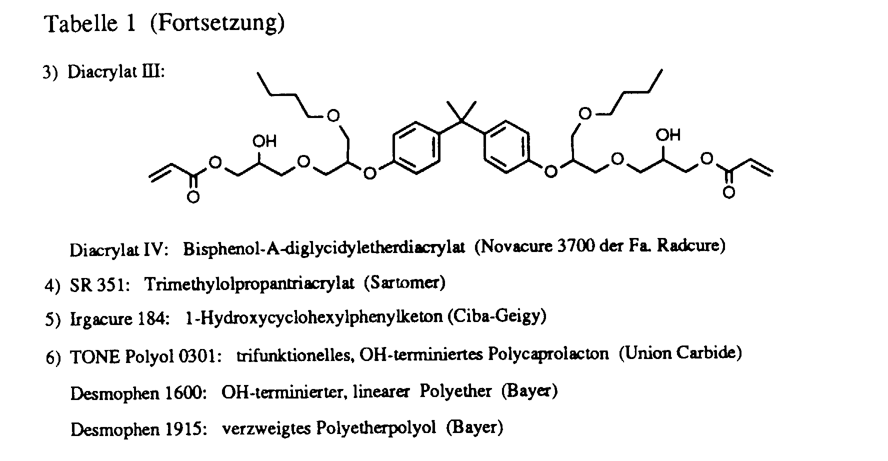

**Tabelle 2**

| Beispiel | 3 | 4 | 5 | 6 | 7 | 8 | 9 | 10 | 11 | 12 | 13 |
|---|---|---|---|---|---|---|---|---|---|---|---|
| Bestrahlungsenergie [mJ/cm²] | 80 | 160 | 160 | 80 | 40 | 40 | 160 | 160 | 160 | 160 | 160 |
| E-Modul [N/mm²]²⁾ | 464 | 101 | 764 | 962 | 710 | 795 | 1404 | 1026 | 691 | 874 | 991 |
| Reissdehnung [%]²⁾ | 11,7 | 10,8 | 12,6 | 17 | 39,6 | 38,9 | 17,6 | 51,8 | 11,4 | 8,6 | 9,7 |
| E-Modul [N/mm²]³⁾ | 1151 | 1022 | 1560 | 1139 | 1300 | 1344 | 1267 | 1611 | 1481 | 1673 | 1890 |
| Reissdehnung [%]³⁾ | 14,4 | 5,0 | 5,4 | 14,4 | 32,6 | 46,4 | 4,4 | 19,7 | 7,3 | 5,3 | 6,5 |
| CF 6⁴⁾ | 0,01 | -0,01 | 0 | -0,04 | -0,01 | -0,03 | -0,03 | -0,04 | -0,03 | -0,02 | 0 |
| CF 11⁴⁾ | 0 | 0.01 | 0 | 0 | 0,04 | 0,01 | -0,02 | 0 | -0,02 | 0,01 | -0,02 |

| | | | | | | | | | | | |
|---|---|---|---|---|---|---|---|---|---|---|---|
| 2) Werte nach Laserhärtung mit der angegebenen Bestrahlungsenergie | | | | | | | | | | | |
| 3) Werte nach vollständiger Aushärtung (30 min UV, 30 min 130 °C) | | | | | | | | | | | |
| 4) Curl-Faktoren (bestimmt an Körpern, die mit einer Schichtdicke von 0,076 mm aufgebaut wurden) | | | | | | | | | | | |

### Beispiel 14:

48,4 g 3,4-Epoxycyclohexylmethyl-3',4'-epoxycyclohexancarboxylat werden mit 18 g Butandioldiglycidylether, 20 g eines trifunktionellen, OH-terminierten Polycaprolactons (TONE® Polyol 0301 der Fa. Union Carbide), 8 g Bisphenol-A-diglycidylether-diacrylat (Novacure® 3700 der Fa. Radcure) und 4 g Dipentaerythritolmonohydroxypentaacrylat (SR® 399 der Fa. Sartomer) bei 60 °C vermischt. Anschliessend werden 0,8 g 1-Hydroxycyclohexylphenylketon (Irgacure® 184 der Fa. Ciba-Geigy) und 0,8 g Triarylsulfoniumhexafluoroantimonat (Cyracure® UVI 6974 der Fa. Union Carbide) hinzugegeben, und das Gemisch wird dann solange gerührt, bis eine klare homogene Mischung entsteht. Die flüssige Formulierung hat bei 30 °C eine Viskosität von 194 mPa·s.
Mit Hilfe eines He/Cd-Lasers (Bestrahlungsenergie: 160 mJ/cm²) werden Formkörper hergestellt. Nach der Laserhärtung (Grünlinge) haben diese Körper folgende Eigenschaften:

| | |
|---|---|
| E-Modul: | 55,4 N/mm² |
| Reissdehnung: | 17 % |

Zur vollständigen Aushärtung werden die Grünlinge 30 Minuten mit UV-Licht bestrahlt und 30 Minuten auf 130 °C erwärmt. Die Körper weisen anschliessend folgende Eigenschaften auf:

| | |
|---|---|
| E-Modul: | 2466 N/mm² |
| Reissdehnung: | 11,2 % |
| Curl-Faktor: | CF 6 weave*: -0,02. |

| | |
|---|---|
| *"CF₆ weave" wird an Prüfkörpern bstimmt, die mit dem Baustil "weave" aufgebaut werden (siehe hierzu "Rapid Prototyping and Manufacturing, Fundamentals of Stereolithography, P. F. Jacobs ed., SME 1992, Seite 199 ff). | |

## Patentansprüche

1. Photoempfindliche Zusammensetzungen enthaltend
A) 40-80 Gew.-% mindestens eines flüssigen Epoxyharzes mit einer Epoxidfunktionalität von gleich oder grösser als 2,
B) 0,1-10 Gew.-% mindestens eines kationischen Photoinitiators für Komponente A),
C) 5-40 Gew.-% mindestens eines flüssigen cycloaliphatischen oder aromatischen Diacrylats,
D) 0-15 Gew.-% mindestens eines flüssigen Poly(meth-)acrylats mit einer (Meth-)Acrylatfunktionalität von grösser als 2, wobei der Gehalt an Komponente D) am gesamten (Meth)Acrylatgehalt höchstens 50 Gew.-% beträgt,
E) 0,1-10 Gew.-% mindestens eines radikalischen Photoinitiators für die Komponenten C) und gegebenenfalls D) und
F) 5-40 Gew.-% mindestens eines OH-terminierten Polyethers, Polyesters oder Polyurethans.

2. Photoempfindliche Zusammensetzungen gemäss Anspruch 1, wobei der Gehalt an Komponente D) am gesamten (Meth)Acrylatgehalt höchstens 40 Gew.-% beträgt.

3. Photoempfindliche Zusammensetzungen gemäss Anspruch 1, enthaltend
A) 50-75 Gew.-% mindestens eines flüssigen Epoxyharzes mit einer Epoxidfunktionalität von gleich oder grösser als 2,
B) 0,2-5 Gew.-% mindestens eines kationischen Photoinitiators für Komponente A),
C) 5-20 Gew.-% mindestens eines flüssigen cycloaliphatischen oder aromatischen Diacrylats,
D) 0-10 Gew.-% mindestens eines flüssigen Polyacrylats mit einer Acrylatfunktionalität von grösser als 2, wobei der Gehalt an Komponente D) am gesamten Acrylatgehalt höchstens 50 Gew.-% beträgt,
E) 0,2-5 Gew.-% mindestens eines radikalischen Photoinitiators für die Komponenten C) und gegebenenfalls D) und
F) 10-40 Gew.-% mindestens eines OH-terminierten Polyethers, Polyesters oder Polyurethans.

4. Photoempfindliche Zusammensetzungen gemäss Anspruch 1, worin die Komponente A) mindestens 50 Gew.-% eines cycloaliphatischen Diepoxids enthält.

5. Photoempfindliche Zusammensetzungen gemäss Anspruch 4, wobei das cycloaliphatische Diepoxid Bis-(4-hydroxycyclohexyl)-methandiglycidylether,2,2-Bis-(4-hydroxycyclohexyl)-propandiglycidylether, 3,4-Epoxycyclohexylmethyl-3,4epoxycyclohexancarboxylat, 3,4-Epoxy-6-methyl-cyclohexylmethyl-3,4-epoxy-6-methylcyclohexancarboxylat, Di-(3,4-epoxycyclohexylmethyl)hexandioat, Di-(3,4-epoxy-6-methyl-cyclohexylmethyl)hexandioat, Ethylenbis-(3,4-epoxycyclohexancarboxylat), Ethandioldi-(3,4-epoxycyclohexylmethyl)-ether oder 2-(3,4-Epoxycyclohexyl-5,5-spiro-3,4-epoxy)cyclohexan-1,3-dioxan ist.

6. Photoempfindliche Zusammensetzungen gemäss Anspruch 1, enthaltend als Komponente B) eine Verbindung der Formeln I, II oder III 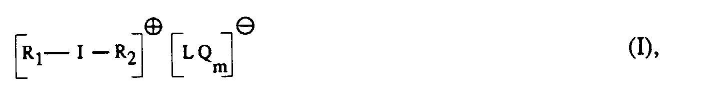 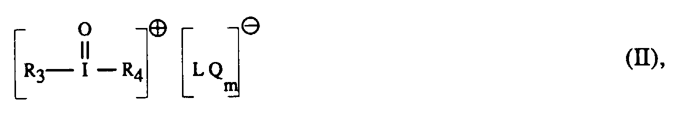 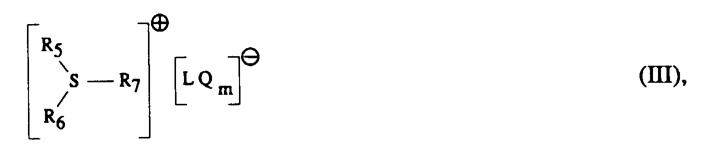 worin R₁, R₂, R₃, R₄, R₅, R₆ und R₇ unabhängig voneinander unsubstituiertes oder durch geeignete Reste substituiertes C₆-C₁₈-Aryl bedeuten,
L Bor, Phosphor, Arsen oder Antimon darstellt,
Q ein Halogenatem ist oder ein Teil der Reste Q in einem Anion LQₘ⁻ auch Hydroxylgruppen sein kann und
m eine ganze Zahl ist, die der um 1 vergrösserten Wertigkeit von L entspricht.

7. Photoempfindliche Zusammensetzungen gemäss Anspruch 1, enthaltend als Komponente B) eine Verbindung der Formel IV 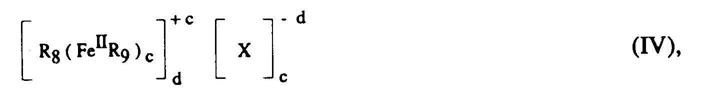 worin
c 1 oder 2 bedeutet,
d 1, 2, 3, 4 oder 5 ist,
X für ein nicht nukleophiles Anion, insbesondere PF₆⁻, AsF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻ und n-C₈F₁₇SO₃⁻ steht,
R₈ ein π-Aren ist und
R₉ ein Anion eines π-Arens, insbesondere ein Cyclopentadienylanion, bedeutet.

8. Photoempfindliche Zusammensetzungen gemäss Anspruch 6, enthaltend als Komponente B) eine Verbindung der Formel III, worin R₅, R₆ und R₇ Aryl sind.

9. Photoempfindliche Zusammensetzungen gemäss Anspruch 1, enthaltend als Komponente C) eine Verbindung der Formeln V, VI, VII oder VIII 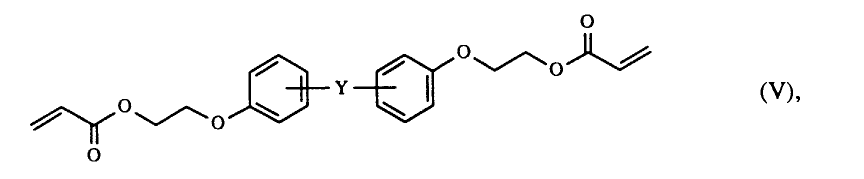 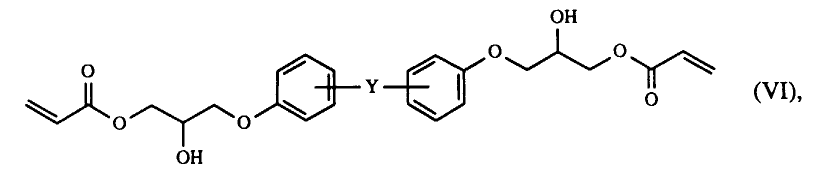 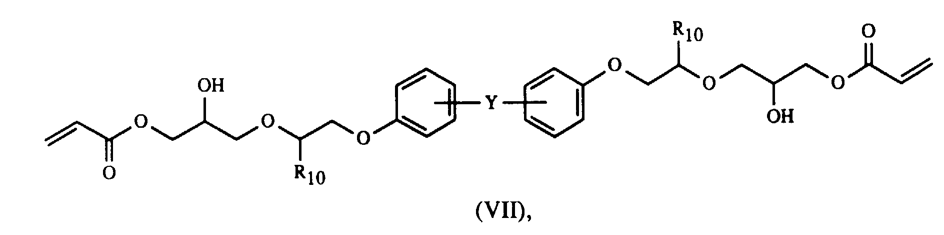 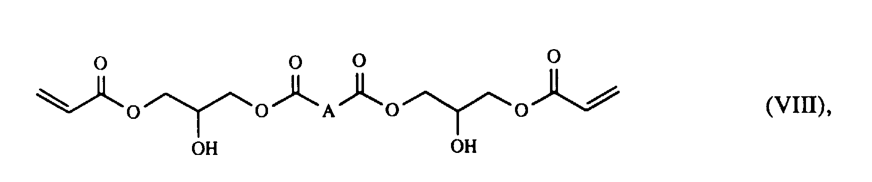 wobei Y für eine direkte Bindung, C₁-C₆-Alkylen, -S-, -O-, -SO-, -SO₂- oder -CO- steht,
R₁₀ für eine C₁-C₈-Alkylgruppe, eine unsubstituierte oder durch eine oder mehrere C₁-C₄-Alkylgruppen, Hydroxygruppen oder Halogenatome substituierte Phenylgruppe, oder für einen Rest der Formel -CH₂-OR₁₁ steht, worin
R₁₁ eine C₁-C₈-Alkylgruppe oder Phenylgruppe bedeutet,
A einen Rest der Formeln 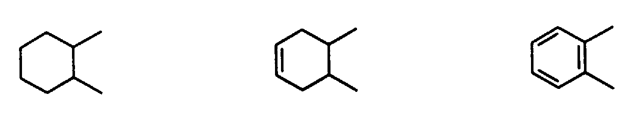 darstellt,
oder enthaltend als Komponente C) eine Verbindung der Formeln IXa bis IXd 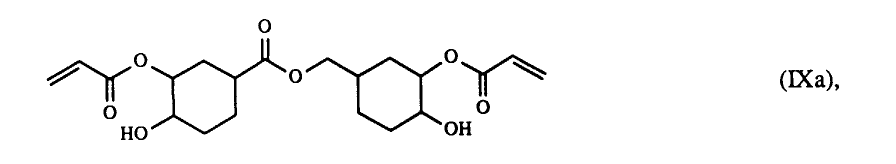 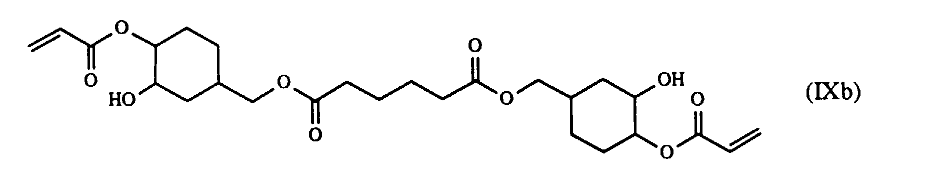 und die entsprechende Isomere,

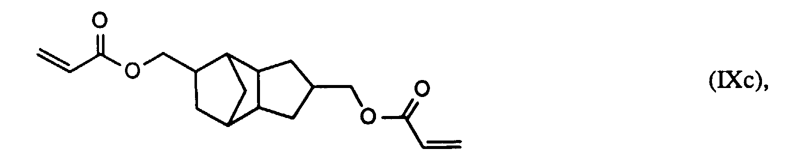

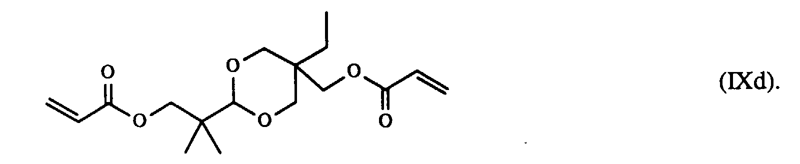

10. Photoempfindliche Zusammensetzungen gemäss Anspruch 9, worin in den Formeln V, VI oder VII Y als Alkylen -CH₂- oder -C(CH₃)₂- ist.

11. Photoempfindliche Zusammensetzungen gemäss Anspruch 9, worin in der Formel VII R₁₀ für n-Butyl, Phenyl, n-Butoxymethyl oder Phenoxymethyl steht.

12. Photoempfindliche Zusammensetzungen gemäss Anspruch 1, worin die Komponente D) ein Tri(meth-)acrylat oder ein Penta(meth-)acrylat ist.

13. Photoempfindliche Zusammensetzungen gemäss Anspruch 12, worin das Penta(meth-)acrylat Dipentaerythritolmonohydroxypenta(meth-)acrylat ist.

14. Photoempfindliche Zusammensetzungen gemäss Anspruch 1, enthaltend als Komponente E) ein 1-Hydroxyphenylketon.

15. Photoempfindliche Zusammensetzungen gemäss Anspruch 14, worin das 1-Hydroxyphenylketon 1 -Hydroxycyclohexylphenylketon ist.

16. Photoempfindliche Zusammensetzungen gemäss Anspruch 1, enthaltend als Komponente F) ein lineares oder verzweigtes Polyesterpolyol.

17. Photoempfindliche Zusammensetzungen gemäss Anspruch 1, enthaltend als Komponente F) ein trifunktionelles, OH-terminiertes Polycaprolacton.

18. Photoempfindliche Zusammensetzungen gemäss Anspruch 1, enthaltend
als Komponente A) ein cycloaliphatisches Diepoxid und einen aliphatischen Polyglycidylether,
als Komponente B) Triarylsulfoniumhexafluoroantimonat,
als Komponente C) eine Verbindung der Formel VI, worin Y -CH₂- oder -C(CH₃)₂- ist,
als Komponente D) ein Tri(meth-)acrylat oder ein Penta(meth-)acrylat,
als Komponente E) ein 1-Hydroxyphenylketon und
als Komponente F) ein lineares oder verzweigtes Polyesterpolyol.

19. Verfahren zum Polymerisieren der Zusammensetzungen gemäss Anspruch 1, indem diese mit aktinischem Licht bestrahlt werden.

20. Verfahren zur Herstellung von dreidimensionalen Gegenständen aus einer Zusammensetzung gemäss Anspruch 1 mittels einem lithographischen Verfahren, wobei die Oberfläche einer Schicht der besagten Zusammensetzung ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht dieser Zusammensetzung auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

21. Verfahren gemäss Anspruch 20, worin die UV/VIS-Lichtquelle ein Laserstrahl, vorzugsweise ein computergesteuerter Laserstrahl, ist.

22. Verwendung einer Zusammensetzung gemäss Anspruch 1 zur Herstellung von photopolymerisierten Schichten, insbesondere in Form von dreidimensionalen Gegenständen, die aus mehreren aneinander haftenden, verfestigten Schichten aufgebaut sind.

## Claims

1. A photosensitive composition comprising
A) from 40 to 80 % by weight of at least one liquid epoxy resin having an epoxy functionality of equal to or greater than 2,
B) from 0.1 to 10 % by weight of at least one cationic photoinitiator for component A),
C) from 5 to 40 % by weight of at least one liquid cycloaliphatic or aromatic diacrylate,
D) from 0 to 15 % by weight of at least one liquid poly(meth-)acrylate having a (meth-)-acrylate functionality of greater than 2, the proportion of component D) constituting a maximum of 50 % by weight of the total (meth-)acrylate content,
E) from 0.1 to 10 % by weight of at least one radical photoinitiator for component C) and, where appropriate, component D) and
F) from 5 to 40 % by weight of at least one OH-terminated polyether, polyester or polyurethane.

2. A photosensitive composition according to claim 1 wherein the proportion of component D) constitutes a maximum of 40 % by weight of the total (meth)acrylate content.

3. A photosensitive composition according to claim 1 comprising
A) from 50 to 75 % by weight of at least one liquid epoxy resin having an epoxy functionality of equal to or greater than 2,
B) from 0.2 to 5 % by weight of at least one cationic photoinitiator for component A),
C) from 5 to 20 % by weight of at least one liquid cycloaliphatic or aromatic diacrylate,
D) from 0 to 10 % by weight of at least one liquid polyacrylate having an acrylate functionality of greater than 2, the proportion of component D) constituting a maximum of 50 % by weight of the total acrylate content,
E) from 0.2 to 5 % by weight of at least one radical photoinitiator for component C) and, where appropriate, component D) and
F) from 10 to 40 % by weight of at least one OH-terminated polyether, polyester or polyurethane.

4. A photosensitive composition according to claim 1 wherein component A) comprises at least 50 % by weight of a cycloaliphatic diepoxide.

5. A photosensitive composition according to claim 4 wherein the cycloaliphatic diepoxide is bis(4-hydroxycyclohexyl)methane diglycidyl ether, 2,2-bis(4-hydroxycyclohexyl)propane diglycidyl ether, 3,4-epoxycyclohexylmethyl-3,4-epoxycyclohexanecarboxylate, 3,4-epoxy-6-methyl-cyclohexylmethyl-3,4-epoxy-6-methylcyclohexanecarboxylate, di-(3,4-epoxycyclohexylmethyl)hexanedioate, di-(3,4-epoxy-6-methyl-cyclohexylmethyl)hexanedioate, ethylenebis(3,4-epoxycyclohexanecarboxylate), ethanediol di-(3,4-epoxycyclohexylmethyl) ether or 2-(3,4-epoxycyclohexyl-5,5-spiro-3,4-epoxy)cyclohexane-1,3-dioxane.

6. A photosensitive composition according to claim 1 comprising as component B) a compound of the formula I, II or III 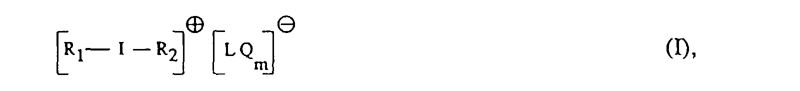 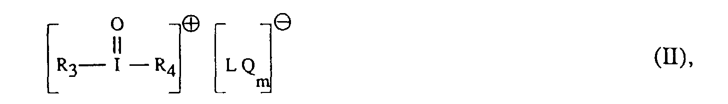 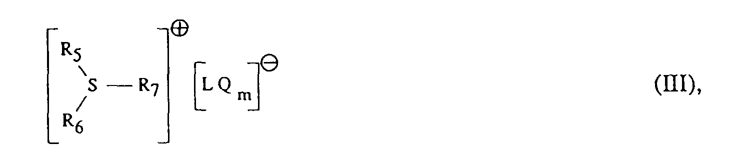 wherein R₁, R₂, R₃, R₄, R₅, R₆ and R₇ are each independently of the others C₆-C₁₈aryl that is unsubstituted or substituted by suitable radicals,
L is boron, phosphorus, arsenic or antimony,
Q is a halogen atom or some of the radicals Q in an anion LQₘ⁻ may also be hydroxy groups, and
m is an integer that corresponds to the valency of L plus 1.

7. A photosensitive composition according to claim 1 comprising as component B) a compound of formula IV 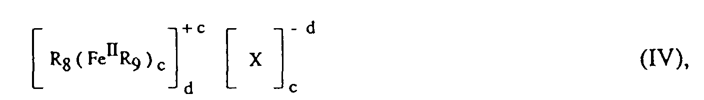 wherein
c is 1 or 2,
d is 1, 2, 3, 4 or 5,
X is a non-nucleophilic anion, especially PF₆⁻, AsF₆⁻, SbF₆⁻, CF₃SO₃⁻, C₂F₅SO₃⁻. n-C₃F₇SO₃⁻, n-C₄F₉SO₃⁻, n-C₆F₁₃SO₃⁻ or n-C₈F₁₇SO₃⁻ ,
R₈ is a π-arene and
R₉ is an anion of a π-arene, especially a cyclopentadienyl anion.

8. A photosensitive composition according to claim 6 comprising as component B) a compound of formula III wherein R₅, R₆ and R₇ are aryl.

9. A photosensitive composition according to claim 1 comprising as component C) a compound of formula V, VI, VII or VIII 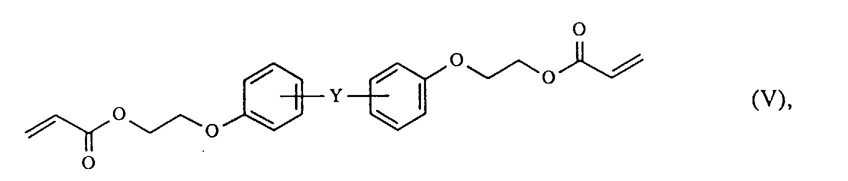 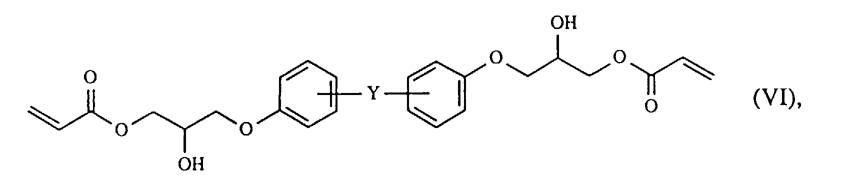 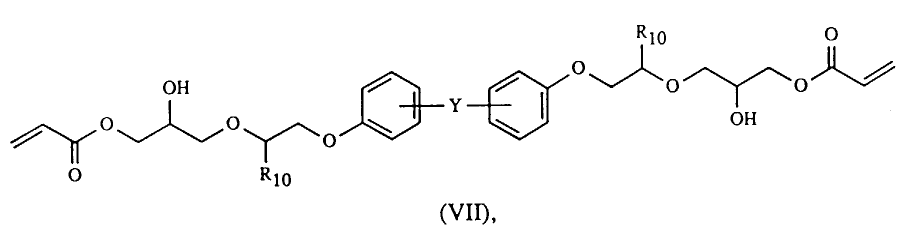 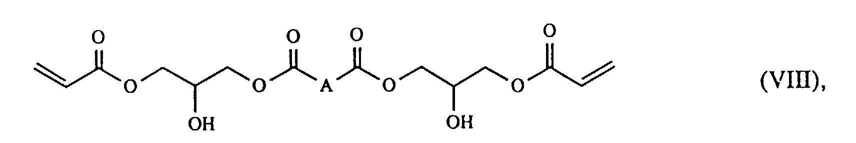 wherein
Y is a direct bond, C₁-C₆alkylene, -S-, -O-, -SO-, -SO₂- or -CO-,
R₁₀ is a C₁-C₈alkyl group, a phenyl group that is unsubstituted or substituted by one or more C₁-C₄alkyl groups, hydroxy groups or halogen atoms, or a radical of the formula -CH₂-OR₁₁, wherein
R₁₁ is a C₁-C₈alkyl group or a phenyl group, and
A is a radical of the formula 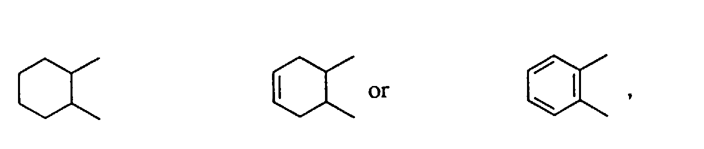
or comprising as component C) a compound of any one of formulae IXa to IXd 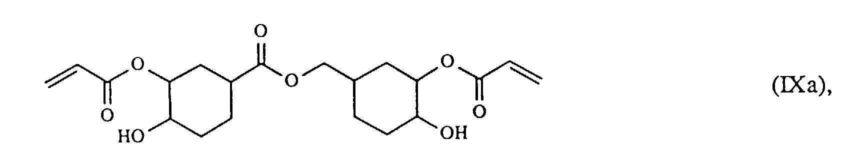 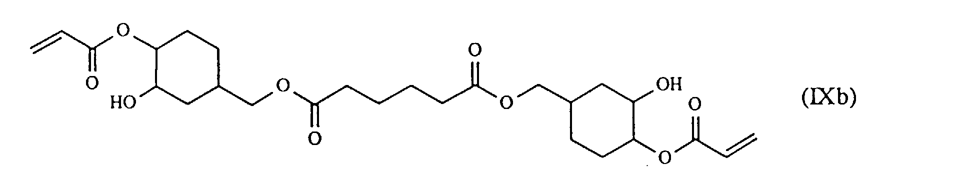 and the corresponding isomers,

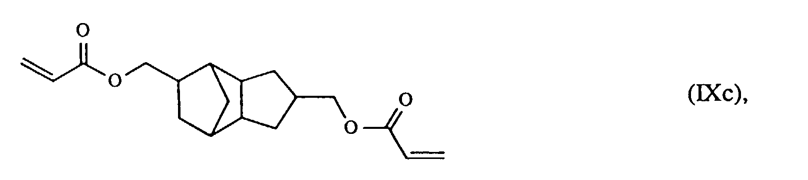

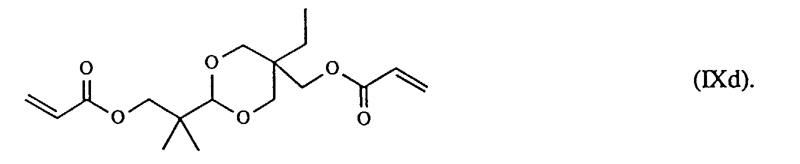

10. A photosensitive composition according to claim 9 wherein in formula V, VI or VII Y as alkylene is -CH₂- or -C(CH₃)₂-.

11. A photosensitive composition according to claim 9 wherein in formula VII R₁₀ is n-butyl, phenyl, n-butoxymethyl or phenoxymethyl.

12. A photosensitive composition according to claim 1 wherein component D) is a tri(meth-)acrylate or a penta(meth-)acrylate.

13. A photosensitive composition according to claim 12 wherein the penta(meth-)acrylate is dipentaerythritol monohydroxypenta(meth-)acrylate.

14. A photosensitive composition according to claim 1 comprising as component E) a 1-hydroxyphenyl ketone.

15. A photosensitive composition according to claim 14 wherein the 1-hydroxyphenyl ketone is 1-hydroxycyclohexyl phenyl ketone.

16. A photosensitive composition according to claim 1 comprising as component F) a linear or branched polyester polyol.

17. A photosensitive composition according to claim 1 comprising as component F) a trifunctional, OH-terminated polycaprolactone.

18. A photosensitive composition according to claim 1 comprising
as component A) a cycloaliphatic diepoxide and an aliphatic polyglycidyl ether,
as component B) triarylsulfonium hexafluoroantimonate,
as component C) a compound of formula VI wherein Y is -CH₂- or -C(CH₃)₂-,
as component D) a tri(meth-)acrylate or a penta(meth-)acrylate,
as component E) a 1-hydroxyphenyl ketone and
as component F) a linear or branched polyester polyol.

19. A process for polymerising the composition according to claim 1 by irradiating it with actinic light.

20. A process for the manufacture of three-dimensional objects from a composition according to claim 1 by means of a lithographic process, wherein the surface of a layer of the said composition, in its entirety or in a predetermined pattern, is irradiated with a UV/VIS light source so that a layer of a desired thickness solidifies in the irradiated areas and then a new layer of that composition is formed on the solidified layer, the new layer likewise being irradiated over the entire surface or in a predetermined pattern, and, by repeated layering and irradiation, three-dimensional objects comprising several solidified layers adhering to one another are obtained.

21. A process according to claim 20, wherein the UV/VIS light source is a laser beam, preferably a computer-controlled laser beam.

22. The use of a composition according to claim 1 in the manufacture of photopolymerised layers, especially in the form of three-dimensional objects that are made up of several solidified layers adhering to one another.

## Revendications

1. Compositions photosensibles contenant
A) 40 à 80% en poids d'une résine époxy liquide avec une fonctionnalité époxyde égale ou supérieure à 2,
B) 0,1 à 10% en poids d'un photo-amorceur cationique pour le composant A),
C) 5 à 40% en poids d'au moins un diacrylate cycloaliphatique ou aromatique liquide,
D) 0 à 15% en poids d'au moins un poly(méth)acrylate avec une fonctionnalité (méth)acrylate supérieure à 2, la teneur en composant D) représentant au plus 50% de la teneur totale en (méth)acrylates,
E) 0,1 à 10% en poids d'au moins un photo-amorceur radicalaire pour le composant C) et le cas échéant D), et F) 5 à 40% en poids d'au moins un polyéther, un polyester ou un polyuréthanne à terminaison OH.

2. Compositions photosensibles selon la revendication 1, dans lesquelles la teneur en composant D) représente au plus 40% de la teneur totale en (méth)acrylate.

3. Compositions photosensibles selon la revendication 1, contenant
A) 50 à 75% en poids d'une résine époxy liquide avec une fonctionnalité époxyde égale ou supérieure à 2,
B) 0,2 à 5% en poids d'un photo-amorceur cationique pour le composant A),
C) 5 à 20% en poids d'au moins un diacrylate cycloaliphatique ou aromatique liquide,
D) 0 à 10% en poids d'au moins un poly(méth)acrylate avec une fonctionnalité (méth)acrylate supérieure à 2, la teneur en composant D) représentant au plus 50% de la teneur totale en (méth)acrylates,
E) 0,2 à 5% en poids d'au moins un photo-amorceur radicalaire pour le composant C) et le cas échéant D), et
F) 10 à 40% en poids d'au moins un polyéther, un polyester ou un polyuréthanne à terminaison OH.

4. Compositions photosensibles selon la revendication 1, dans lesquelles le composant A) contient au moins 50% en poids d'un diépoxyde cycloaliphatique.

5. Compositions photosensibles selon la revendication 4, dans lesquelles le diépoxyde cycloaliphatique est le bis-(4-hydroxycyclohexyl)-méthane diglycidyléther, le 2,2-bis4-hydroxycyclohexyl)-propane diglycidyléther, le carboxylate de 3,4-époxycyclohexylméthyl-3,4-époxycyclohexane, le carboxylate de 3,4-époxy-6-méthyl-cyclohexylméthyl-3,4-époxycyclohexane, le di-(3,4-époxycyclohexylméthyl)hexanedioate, le di-(3,4-époxy-6-méthyl-cyclohexylméthyl)hexanedioate, le carboxylate d'éthylène-bis-(3,4-époxycyclohexane), l'éthanediol-di-(3,4-époxycyclohexylméthyl)-éther ou le 2-(3,4-époxycyclohexyl-5,5-spiro-3,4-époxy)cyclohexane-1,3-dioxane.

6. Compositions photosensibles selon la revendication 1, contenant comme composant B un composé des formules I, II ou III 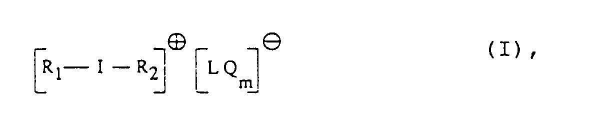 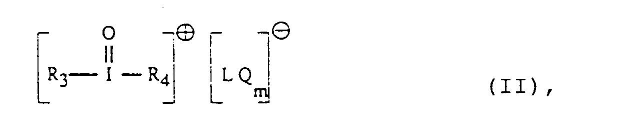 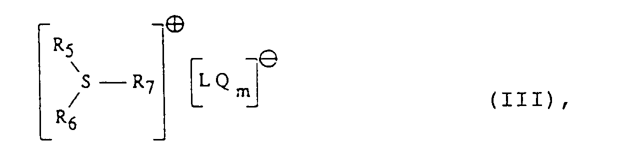 dans lesquelles R₁, R₂, R₃, R₄, R₅, R₆ et R₇ représentent indépendamment les uns des autres un aryle en C₆-C₁₈ non substitué ou substitué par des restes appropriés,
L représente le bore, le phosphore, l'arsenic ou l'antimoine,
Q est un atome d'halogène ou bien une partie des restes Q dans un anion LQₘ⁻ peut également être un groupe hydroxyle, et
m est un entier correspondant à la valence de L augmentée de 1.

7. Compositions photosensibles selon la revendication 1, contenant comme composant B) un composé de la formule IV 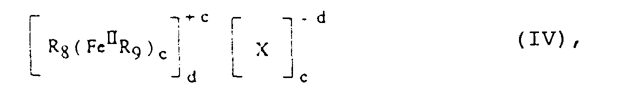 dans laquelle c est égal à 1 ou 2,
d est égal à 1, 2, 3, 4 ou 5,
X représente un anion non nucléophile, notamment le PF₆⁻, l'AsF₆⁻, le SbF₆⁻, le CF₃SO₃⁻, le C₂F₅SO₃⁻, le n-C₃F₇SO₃⁻, le n-C₄F₉SO₃⁻, le n-C₆F₁₃SO₃⁻ et le n-C₈F₁₇SO₃⁻,
R₈ est un p-arène, et
R₉ est un anion d'un p-arène, notamment un anion cyclopentadiényle.

8. Compositions photosensibles selon la revendication 6, contenant comme composant B) un composé de la formule III, dans laquelle R₅, R₆ et R₇ sont des groupes aryle.

9. Compositions photosensibles selon la revendication 1, contenant comme composant C) un composé des formules V, VI, VII ou VIII 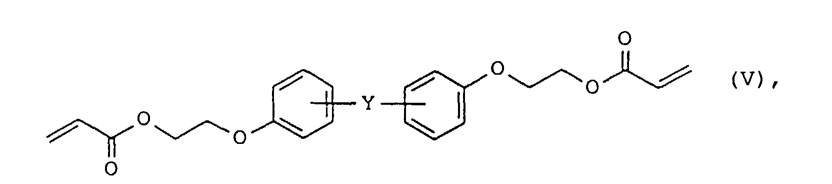 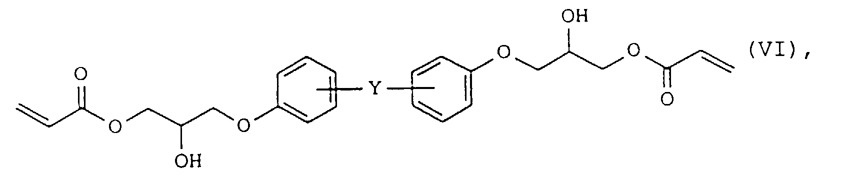 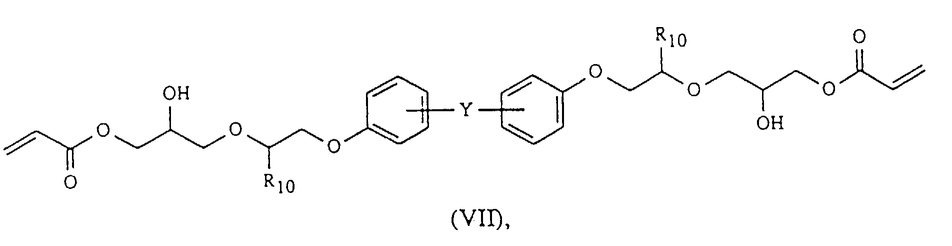 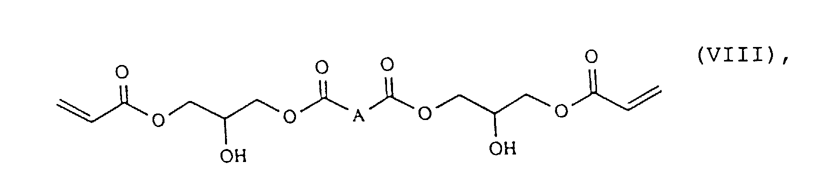 dans lesquelles Y représente une liaison directe, un alkylène en C₁-C₆, -S-, -O-, -SO-, -SO₂- ou -CO-,
R₁₀ représente un groupe alkyle en C₁-C₈, un groupe phényle non substitué ou substitué par un ou plusieurs groupes alkyle en C₁-C₄, ou bien un reste de la formule -CH₂-OR₁₁, dans lequel R₁₁ signifie un groupe alkyle en C₁-C₈ ou un groupe phényle,
A représente un reste des formules 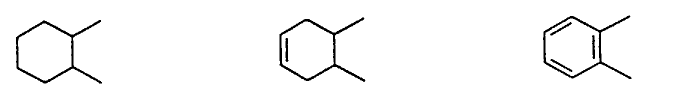 ou bien contenant comme composant C) un composé des formules IXa à IXd 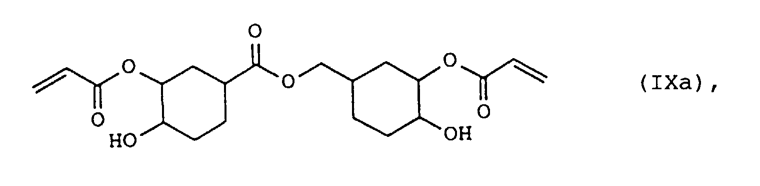 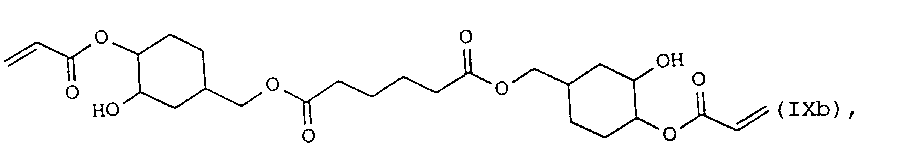 et les isomères correspondants

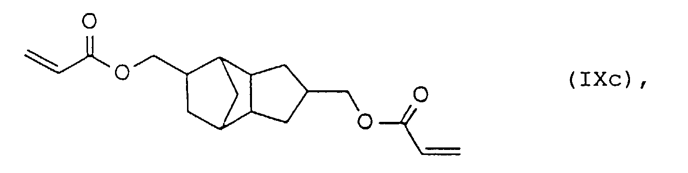

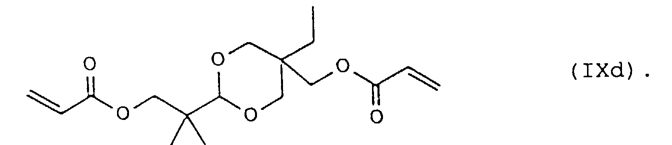

10. Compositions photosensibles selon la revendication 9, dans lesquelles, dans les formules V, VI ou VII, Y représente un alkylène -CH₂- ou -C(CH₃)₂-.

11. Compositions photosensibles selon la revendication 9, dans lesquelles, dans la formule VII, R₁₀ représente le n-butyle, le phényle, le n-butoxyméthyle ou le phénoxyméthyle.

12. Compositions photosensibles selon la revendication 1, dans lesquelles le composant D) est un tri(méth)acrylate ou un penta(méth)acrylate.

13. Compositions photosensibles selon la revendication 1, dans lesquelles le penta(méth)acrylate est du monohydroxypenta(méth)acrylate de dipentaérythritol.

14. Compositions photosensibles selon la revendication 1, contenant comme composant E) une 1-hydroxyphénylcétone.

15. Compositions photosensibles selon la revendication 14, dans lesquelles la 1-hydroxyphénylcétone est la 1-hydroxycyclohexylphénylcétone.

16. Compositions photosensibles selon la revendication 1, contenant comme composant F) un polyester polyol linéaire ou ramifié.

17. Compositions photosensibles selon la revendication 1, contenant comme composant F) une polycaprolactone trifonctionnelle à terminaison OH.

18. Compositions photosensibles selon la revendication 1, contenant
comme composant A) un diépoxyde cycloaliphatique et un polyglycidyléther aliphatique,
comme composant B) un hexafluoroantimoniate de triarylsulfonium,
comme composant C) un composé de la formule VI, dans laquelle Y est -CH₂- ou -C(CH₃)₂-,
comme composant D) un tri(méth)acrylate ou un penta(méth)acrylate,
comme composant E) une 1-hydroxyphénylcétone, et comme composant F) un polyester polyol linéaire ou ramifié.

19. Procédé de polymérisation des compositions selon la revendication 1, dans lequel celles-ci sont insolées avec de la lumière actinique.

20. Procédé de fabrication d'objets en trois dimensions à partir d'une composition selon la revendication 1 au moyen d'un procédé lithographique, dans lequel la surface d'une couche de ladite composition est insolée sur toute sa superficie ou selon un motif prédéterminé avec une source de lumière UV/visible, de manière à stabiliser dans la zone insolée une couche ayant une épaisseur de couche voulue, dans lequel une nouvelle couche de cette composition est ensuite formée sur la couche stabilisée et elle aussi insolée sur toute sa superficie ou selon un motif prédéterminé, et dans lequel on obtient par des revêtements et des insolations répété(e)s des objets en trois dimensions constitués de plusieurs couches stabilisées adhérant les unes aux autres.

21. Procédé selon la revendication 20, dans lequel la source de lumière UV/visible est un rayon laser, de préférence un rayon laser piloté par ordinateur.

22. Utilisation d'une composition selon la revendication 1 pour réaliser des couches photopolymérisées, notamment sous la forme d'objets en trois dimensions constitués de plusieurs couches stabilisées adhérant les unes aux autres.
